Europäisches Patentamt

European Patent Office

Office européen des brevets

(11) Numéro de publication: **0 109 339**
A2

# DEMANDE DE BREVET EUROPEEN

(21) Numéro de dépôt: 83402167.7

(22) Date de dépôt: 08.11.83

(51) Int. Cl.³: **G 05 G 1/12**

(30) Priorité: **16.11.82 FR 8219144**

(43) Date de publication de la demande: **23.05.84**
**Bulletin 84/21**

(84) Etats contractants désignés: **DE GB IT NL**

(71) Demandeur: **THOMSON-BRANDT, 173, Boulevard Haussmann, F-75379 Paris Cedex 08 (FR)**

(72) Inventeur: **Pissot, Guy, THOMSON-CSF SCPI 173, bld Haussmann, F-75379 Paris Cedex 08 (FR)**

(74) Mandataire: **Grynwald, Albert et al, THOMSON-CSF SCPI 173, Bld Haussmann, F-75379 Paris Cedex 08 (FR)**

(54) **Dispositif de sélection de stations pour un récepteur radiophonique.**

(57) Dispositif de sélection de stations pour un récepteur radiophonique comprenant un bouton de commande rotatif (10) pour entraîner un élément d'un organe d'accord qui est mobile entre deux positions extrêmes, cet entraînement étant effectué par l'intermédiaire d'un moyen faisant intervenir un coefficient de frottement, entre un arbre (15) solidaire du bouton (10) et un organe entraîné, de valeur suffisamment élevée pour effectuer l'entraînement lorsque l'élément mobile est entre ses positions extrêmes et suffisamment faible pour provoquer un glissement de l'arbre contre l'organe précédemment entraîné lorsque l'élément mobile est en fin de course.

L'organe entraîné est un coussinet cylindrique (16) dans lequel tourillonne l'arbre (15). De préférence ce coussinet (16) est élastique au moins en direction radiale.

ACTORUM AG

0109339

1

# DISPOSITIF DE SELECTION DE STATIONS POUR UN RECEPTEUR RADIOPHONIQUE.

L'invention est relative à un dispositif de sélection de stations pour un récepteur radiophonique.

Pour la sélection des stations on utilise habituellement un condensateur dont la capacité dépend de la position d'un élément mobile tel qu'une lamelle métallique. Cette position, et donc la fréquence d'accord, c'est-à-dire la station sélectionnée, peut être modifiée grâce à un bouton de commande agissant, par l'intermédiaire d'une liaison mécanique, sur ledit élément mobile du condensateur ou autre organe d'accord. Cet élément mobile ne peut se déplacer qu'entre deux positions extrêmes, des butées étant prévues pour limiter sa course.

Afin de ne pas détériorer la liaison mécanique entre le bouton de commande et l'élément mobile on prévoit généralement un moyen permettant de continuer la rotation du bouton d'entrainement lorsque l'élément mobile est en fin de course. Ce moyen fait intervenir un coefficient de frottement de valeur suffisamment élevée pour permettre l'entrainement mais suffisamment faible pour permettre un glissement (sans entrainement) lorsque l'élément mobile est en fin de course.

Dans les dispositifs connus, ce frottement intervient soit entre un arbre et un cordon, soit entre un arbre et la périphérie d'une roue. De tels dispositifs de sélection sont relativement fragiles ou d'une fiabilité insuffisante à l'égard des exigences actuelles.

L'invention remédie à ces inconvénients.

Elle est caractérisée en ce que ledit coefficient de frottement de valeur suffisamment élevée pour permettre l'entrainement et suffisamment faible pour empêcher cet entrainement lorsque l'élément mobile à entrainer est en fin de course intervient entre l'arbre entrainé par le bouton et un organe cylindrique formant coussinet au centre d'une roue.

Un tel dispositif est d'une grande simplicité et est plus résistant que les dispositifs du même genre connus jusqu'à présent.

Dans le mode de réalisation préféré de l'invention le coussinet est élastique au moins en direction radiale. Il a alors une double fonction : d'une part celle mentionnée ci-dessus et, d'autre part, il constitue un élément de sécurité pour absorber des efforts radiaux et/ou pour rattraper des jeux.

D'autres caractéristiques et avantages de l'invention apparaîtront avec la description de certains de ses modes de réalisation, celle-ci étant effectuée en se référant aux dessins ci-annexés sur lesquels :

- la figure 1 est une vue en coupe d'une partie d'un dispositif de sélection selon l'invention, et

- la figure 2 est une coupe selon la ligne 2-2 de la figure 1.

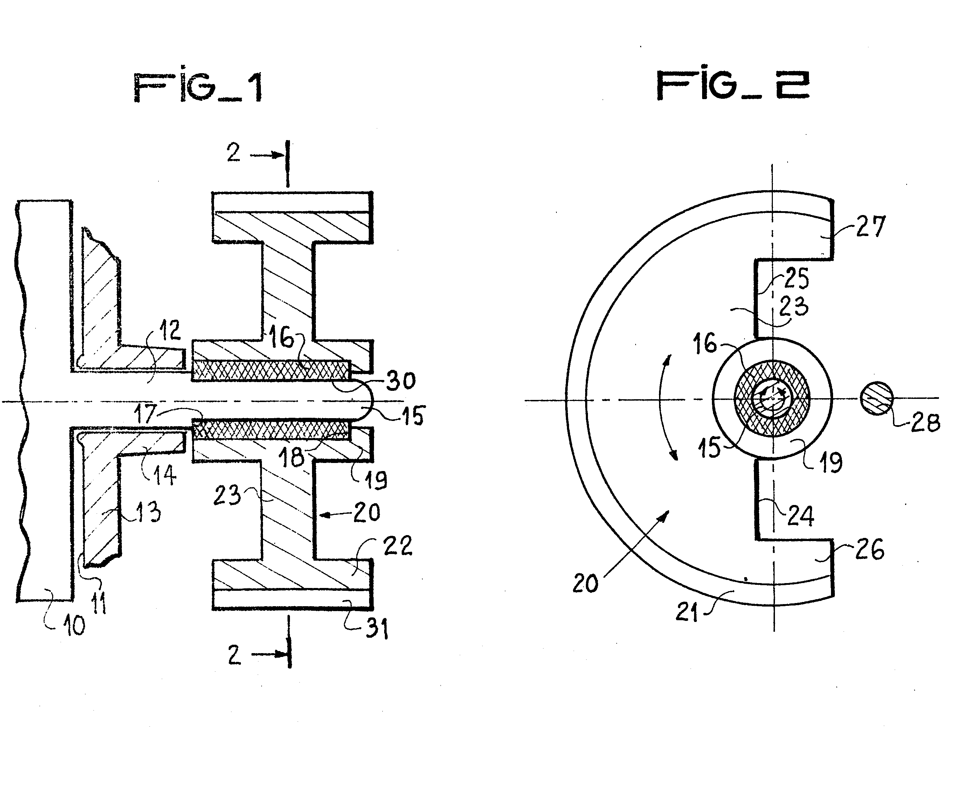

Le dispositif de sélection de stations pour un récepteur radiophonique comprend (figure 1) un bouton de commande 10 apparent sur la façade 11 d'un récepteur radio. Ce bouton est prolongé par un arbre 12 traversant la paroi de façade 13 ainsi qu'un manchon 14 en saillie de cette paroi à l'opposé de la façade 11 proprement dite. L'arbre 12 est lui-même prolongé par un arbre coaxial 15, de plus petit diamètre, qui tourillonne dans un coussinet 16 constitué par un manchon cylindrique ayant des propriétés élastiques au moins en direction radiale.

Une extrémité axiale du manchon 16 est en appui contre l'épaulement 17 séparant les arbres 12 et 15 et l'autre extrémité axiale de ce manchon élastique 16 est en appui contre le fond 18 d'un logement pour ce manchon que présente la partie centrale 19 d'un organe 20 semi-circulaire dans son ensemble. Ce dernier présente sur sa périphérie des dents 21 qui sont destinées à coopérer avec une roue dentée ou une crémaillère pour l'entrainement de l'élément mobile du condensateur à capacité variable ou condensateur d'accord (non représenté).

La partie centrale 19 de l'organe 20 est cylindrique, coaxiale aux arbres 12 et 15 ainsi qu'au manchon 16; elle est séparée d'une partie périphérique 22 en forme de portion de cylindre par un voile 23 de plus faible dimension en direction axiale et qui occupe sensiblement un demi-cercle. Ce voile 23 est limité par des bords rectilignes 24 et 25 perpendiculaires à l'axe et se trouvant dans un plan peu éloigné d'un plan passant par l'axe.

La partie périphérique 22 en forme de portion de cylindre se termine par des extrémités 26 et 27 respectivement en saillie des bords 24 et 25.

Chacun des bords 24 et 25 est destiné à coopérer avec une butée 28 limitant la rotation de l'organe 20 et limitant donc la course de l'élément mobile du condensateur d'accord.

Lorsque les bords 24 et 25 ne sont pas en contact avec la butée 28, l'organe 20 est entrainé par le bouton 10. Par contre lorsque le bord 24 ou 25 arrive contre la butée 28 l'effort exercé sur le bouton 10 provoque le glissement de l'arbre 15 contre la surface interne 30 du manchon ou coussinet élastique 16 sans risque de détérioration pour aucune pièce du dispositif.

Les propriétés d'élasticité en direction radiale du manchon 16 permettent de compenser les jeux, dans cette direction, entre l'organe 20 et l'arbre 15 ou entre cet organe 20 et la pièce qu'il entraine.

En variante la périphérie de l'organe 20 est régulière, c'est-à-dire sans dent 21, et coopère avec un galet.

On remarquera ici que le coussinet élastique en forme de manchon (16) peut être réalisé, par exemple, en un caoutchouc naturel ou synthétique.

# REVENDICATIONS

1. Dispositif de sélection de stations pour un récepteur radiophonique comprenant un bouton de commande rotatif (10) pour entrainer un élément d'un organe d'accord qui est mobile entre deux positions extrêmes, cet entrainement étant effectué par l'intermédiaire d'un moyen faisant intervenir un coefficient de frottement, entre un arbre (15) solidaire du bouton (10) et un organe entrainé, de valeur suffisamment élevée pour effectuer l'entrainement lorsque l'élément mobile est entre ses positions extrêmes et suffisamment faible pour provoquer un glissement de l'arbre contre l'organe précédemment entrainé lorsque l'élément mobile est en fin de course, caractérisé en ce que l'organe entrainé est un coussinet cylindrique (16) dans lequel tourillonne l'arbre (15).

2. Dispositif selon la revendication 1, caractérisé en ce que le coussinet (16) est élastique au moins en direction radiale de façon à constituer un élément de sécurité pour absorber des efforts radiaux et/ou pour rattraper des jeux.

3. Dispositif selon la revendication 1 ou 2, caractérisé en ce que le coussinet est monté dans un logement d'une pièce entrainée (20) présentant des bords (24 et 25) destinés à coopérer avec une butée (28) limitant la course en rotation de ladite pièce (20).

4. Dispositif selon l'une quelconque des revendications précédentes, caractérisé en ce que le coussinet (16) est solidaire d'une pièce (20) présentant des dents (21) à sa périphérie pour entrainer une crémaillère, une roue dentée ou analogue.

0109339

1/1

FIG_1

FIG_2